# FASCICULE DE BREVET EUROPEEN

(11) **EP 1 810 041 B1**
(45) Date de publication et mention de la délivrance du brevet: **28.07.2010**
(21) Numéro de dépôt: 05814798.4
(22) Date de dépôt: 04.11.2005
(51) Int. Cl.: G01R 19/00, G01R 1/20

(54) **DISPOSITIF DE CAPTEUR DE BATTERIE.**
BATTERIESENSORENVORRICHTUNG
BATTERY SENSOR DEVICE

(30) Priorité: 10.11.2004 FR 0411985
(43) Date de publication de la demande: 25.07.2007
(73) Titulaire: Valeo Electronique et Systemes de Liaison, 78180 Montigny le Bretonneux (FR)
(72) Inventeur: MOLY, José, F-31150 GRATENTOUR (FR); CHRETIEN, Louis, F-92500 RUEIL MALMAISON (FR)
(74) Mandataire: de Lambilly Delorme, Marie Pierre
(86) Numéro de dépôt international: PCT/FR2005/002744
(87) Numéro de publication internationale: WO 2006/051190

(56) Documents cités:
- DE-C1- 10 001 345
- DE-U1- 20 318 266
- US-A- 5 378 977
- US-B1- 6 218 805

## Description

L'invention se rapporte à un dispositif de capteur de batterie pour véhicule automobile.

On connaît un dispositif comprenant un moyen de raccordement à un pôle d'une batterie, un shunt de mesure configuré en tant que grille de résistance et une unité électronique reliée à deux branchements du shunt de mesure.

Un tel dispositif se présente sous forme compacte et permet de mesurer le courant de la batterie.

Le shunt de mesure configuré comme grille de résistance comprend deux barreaux de cuivre de connexion destinés à être reliés à l'unité électronique et un élément de résistance inséré entre les deux barreaux et réalisé de préférence en manganin.

L'unité électronique comprend une unité de mesure, d'analyse et de contrôle destinée à détecter le voltage entre les deux barreaux de cuivre de l'élément de résistance, afin de permettre d'en déduire le courant.

On a constaté dans certains cas, une différence de température entre les deux barreaux de cuivre entraînant un effet thermoélectrique aux jonctions cuivre/manganin de sorte que, notamment lorsque courant de batterie est faible, les mesures peuvent être faussées.

L'invention a pour but, dans un tel capteur, de remédier à cet inconvénient.

On connaît de DE10001345C1 un dispositif suivant le préambule de la revendication 1.

Le dispositif selon l'invention est tel que défini à la revendication 1 et un véhicule suivant l'invention est tel que défini à la revendication 3, des perfectionnements ou modes de réalisation avantageux étant définis aux autres revendications.

Ainsi, grâce à cette disposition, on est assuré que les deux barreaux seront sensiblement à la même température et que l'effet thermoélectrique sera réduit.

Suivant un détail constructif, le second barreau comporte des connexions destinées à être reliées à différentes masses.

Le dispositif, selon l'invention, permet à la bride et aux connexions de masses de relier différentes masses pour divers équipements.

L'invention va maintenant être décrite avec plus de détails en se référant à un mode de réalisation particulier donné à titre d'exemple seulement et représenté aux dessins annexés.
Figure 1 est une vue en élévation d'un dispositif, selon l'invention.
Figure 2 est une vue en plan du dispositif de la figure 1.

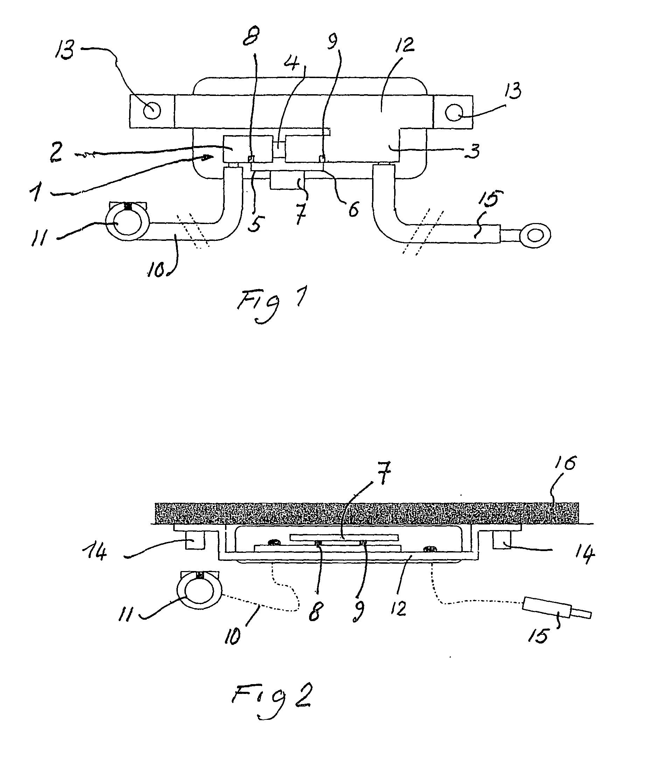

Le dispositif représenté aux figures 1 et 2 comprend un shunt de mesure planaire 1 comprenant un premier barreau de cuivre 2, un second barreau de cuivre 3 et un élément de résistance 4 de préférence en manganin inséré entre les deux.

Les deux barreaux 2 et 3 sont reliés par des conducteurs 5 et 6 respectivement à une carte électronique 7, et comportent des points de mesure 8 et 9 reliés à ladite carte électronique qui comporte des moyens de mesure d'analyse et de contrôle du voltage du shunt de mesure, ces moyens étant de préférence un microprocesseur et une mémoire qui permet de transmettre ces informatisons.

Conformément à l'invention, le barreau 2 est relié à un câble 10 terminé par une cosse 11 destinée à être fixée sur la borne - de la batterie, tandis que le barreau 3 est découpé pour présenter une bride 12 présentant, à ses extrémités, des ouvertures 13 permettant de fixer le dispositif à l'aide de vis 14 sur un élément métallique conducteur de la carrosserie 16 du véhicule par exemple un longeron.

Il peut être prévu un câble 15 solidaire du barreau 3 et destiné à être fixé à une masse par exemple sur la masse moteur du véhicule.

La bride 12 et le câble 15 peuvent constituer des points permettant de connecter des masses pour différents équipements.

Grâce à cette disposition, on est assuré que les deux barreaux de cuivre du shunt de mesure seront sensiblement à la même température de sorte qu'on réduit les effets thermoélectriques.

## Revendications

1. Dispositif de capteur de batterie de véhicule automobile du type comprenant des moyens de raccordement à l'une des bornes de la batterie, un shunt de mesure comportant un élément de résistance et une unité (7) électronique reliée à deux branchements du shunt de mesure avec interposition de capteurs, ladite unité comportant des moyens de mesure de la tension, aux bornes du shunt de mesure permettant d'obtenir le courant de la batterie et d'autres grandeurs indicatrices de la batterie, le shunt de mesure comprenant deux barreaux conducteurs entre lesquels est inséré un élément résistant, un premier barreau (3) est réalisé pour présenter un bride (12) destinée à être fixée sur un élément conducteur métallique du véhicule, **caractérisé en ce que** le deuxième barreau (2) est relié à conducteur (10) terminé par une cosse (11) destiné à être fixée sur la borne négative de la batterie, et **en ce que** des points de mesure (8,9) reliés à l'unité (7) électronique sont situés respectivement sur les premier et deuxième barreaux (2,3) respectifs.

2. Dispositif de capteur de batterie de véhicule automobile, selon la revendication 1, **caractérisé en ce que** le premier barreau comporte des connexions (15) destinées à.être reliées à différentes masses.

3. Véhicule automobile comportant une batterie ayant une borne, une carrosserie (16), et un dispositif suivant la revendication 1 ou 2, **caractérisé en ce que** le deuxième barreau est connecté à la borne de la batterie et le premier barreau est fixé à un élément conducteur métallique de la carrosserie, notamment un longeron.

## Claims

1. Battery sensor device for a motor vehicle, of the type comprising means for connection to one of the terminals of the battery, a measurement shunt comprising a resistive element, and an electronic unit (7) which is connected to two branches of the measurement shunt, with interposition of sensors, the said unit comprising means for measurement of the voltage at the terminals of the measurement shunt which make it possible to determine the current of the battery and other indicative values of the battery, the measurement shunt comprising two conductive bars, between which there is inserted a resistive element, and a first bar (3) is produced such as to have a flange (12) which is designed to be secured to a conductive metal element of the vehicle, **characterised in that** the second bar (2) is connected to a conductor (10) which ends in an eyelet (11) which is designed to be secured to the negative terminal of the battery, and **in that** measurement points (8, 9) which are connected to the electronic unit (7) are situated respectively on the first and second respective bars (2, 3).

2. Battery sensor device for a motor vehicle, according to claim 1, **characterised in that** the first bar comprises connections (15) which are designed to be connected to different earths.

3. Motor vehicle comprising a battery with a terminal, a bodywork (16) and a device according to claim 1 or 2, **characterised in that** the second bar is connected to the terminal of the battery, and the first bar is secured to a conductive metal element of the bodywork, and in particular a sill.

## Patentansprüche

1. Kraftfahrzeug-Batteriesensorenvorrichtung von der Art, die Mittel für den Anschluss an eine der Klemmen der Batterie umfasst, einen Mess-Shunt mit einem Widerstandselement sowie eine Elektronikeinheit (7), die über zwischengeschaltete Sensoren mit zwei Anschlüssen des Mess-Shunts verbunden ist, wobei die besagte Elektronikeinheit Mittel zum Messen der Spannung an den Klemmen des Mess-Shunts umfasst, mit denen der Batteriestrom und sonstige Batteriezustandsgrößen erfasst werden können, und der Mess-Shunt zwei leitende Stäbe umfasst, zwischen denen ein Widerstandselement angeordnet ist, und ein erster Stab (3) so ausgeführt ist, dass er einen Flansch (12) aufweist, der an einem leitenden Metallteil des Fahrzeugs befestigt wird, **dadurch gekennzeichnet, dass** der zweite Stab (2) mit einem Leiter (10) verbunden ist, der in einem Kabelschuh (11) endet, der an der negativen Klemme der Batterie befestigt wird, und **dass** Messpunkte (8, 9), die mit der Elektronikeinheit (7) verbunden sind, auf dem ersten beziehungsweise auf dem zweiten Stab (2, 3) angeordnet sind.

2. Kraftfahrzeug-Batteriesensorenvorrichtung nach Anspruch 1, **dadurch gekennzeichnet, dass** der erste Stab Anschlüsse (15) umfasst, die zum Anschluss an verschiedene Massen vorgesehen sind.

3. Kraftfahrzeug, das eine Batterie mit einer Klemme, eine Karosserie (16) und eine Vorrichtung nach Anspruch 1 oder 2 umfasst, **dadurch gekennzeichnet, dass** der zweite Stab an die Klemme der Batterie angeschlossen und der erste Stab an einem leitenden Metallteil der Karosserie, insbesondere einem Längsträger, befestigt ist.
